(19) **Europäisches Patentamt**
**European Patent Office**
**Office européen des brevets**

(11) **EP 4 481 475 A1**

(12) **EUROPEAN PATENT APPLICATION**
published in accordance with Art. 153(4) EPC

(43) Date of publication:
**25.12.2024 Bulletin 2024/52**

(21) Application number: **22966858.7**

(22) Date of filing: **30.11.2022**

(51) International Patent Classification (IPC):
**G02B 30/27** (2020.01)     **H04N 13/305** (2018.01)

(52) Cooperative Patent Classification (CPC):
**G02B 30/27; H04N 13/305**

(86) International application number:
**PCT/CN2022/135658**

(87) International publication number:
**WO 2024/113267 (06.06.2024 Gazette 2024/23)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(71) Applicant: **Beijing Shiyan Technology Co., Ltd.**
**Beijing 100176 (CN)**

(72) Inventors:
• **GAO, Jian**
**Beijing 100176 (CN)**

• **DONG, Xue**
**Beijing 100176 (CN)**
• **HONG, Tao**
**Beijing 100176 (CN)**
• **PENG, Kuanjun**
**Beijing 100176 (CN)**
• **WU, Zhongyuan**
**Beijing 100176 (CN)**

(74) Representative: **Cohausz & Florack**
**Patent- & Rechtsanwälte**
**Partnerschaftsgesellschaft mbB**
**Bleichstraße 14**
**40211 Düsseldorf (DE)**

(54) **DISPLAY APPARATUS**

(57) A display device includes a display panel (01) and a light splitting assembly (02). The display panel (01) includes pixel repetition units (04), each of which includes pixel islands (S) arranged consecutively in a column direction (Y), each pixel island (S) includes sub-pixels (08) arranged to be spaced apart from each other in a row direction (X), the pixel repetition units (04) include pixel repetition unit rows (013) arranged in the column direction (Y), and the sub-pixels (08) in at least some adjacent two pixel repetition unit rows (013) are staggered in the row direction (X). The light splitting assembly (02) is positioned on a display side of the display panel (01) and includes light splitting repetition units (03) which extend in the column direction (Y) and are consecutively arranged in the row direction (X), the light splitting repetition units (03) include M light splitting structures (A) which extend in the column direction (Y) and are consecutively arranged in the row direction (X), and each light splitting repetition unit (03) corresponds to N columns of the sub-pixels (08) in each pixel repetition unit row (013), where each of M and N is an integer greater than 1, and M is coprime with N.

FIG. 4

## Description

## TECHNICAL FIELD

The present disclosure relates to the field of display technology, and in particular, to a display device.

## BACKGROUND

With continuous development of display technology, three-dimensional (3D) display technology is attracting more and more attention. The three-dimensional display technology can make a display picture become three-dimensional and realistic. The principle thereof is as follows: a left eye image and a right eye image with certain parallax are received by the left eye and the right eye of a person respectively, and after the two parallax images are received by the left eye and the right eye of the person respectively, information of the images is superposed and fused through the brain, such that a 3D visual display effect can be achieved. In order to realize compatibility of super multi-view 3D display and light field display, traditional sub-pixels are formed into pixel island structures, and each pixel island includes a plurality of sub-pixels. In a case where the display information of the plurality of sub-pixels is different from each other and a single eye enters a plurality of views (or viewpoints), traditional light field display can be realized. In a case where the display information of the plurality of sub-pixels is different from each other and a single eye enters a single view, super multi-view light field 3D display can be realized.

However, 3D display products in the prior art have a problem of Moire fringes.

## SUMMARY

Embodiments of the present disclosure provide a display device, including:

a display panel, including a plurality of pixel repetition units arranged in an array along a row direction and a column direction, wherein each of the pixel repetition units includes a plurality of pixel islands arranged consecutively in the column direction, each of the pixel islands includes a plurality of sub-pixels arranged to be spaced apart from each other in the row direction, the plurality of pixel repetition units include a plurality of pixel repetition unit rows arranged in the column direction, and the sub-pixels in one pixel repetition unit row of a pair of adjacent two pixel repetition unit rows of at least some of pairs of adjacent two pixel repetition unit rows are staggered relative to the sub-pixels in the other pixel repetition unit row of the pair of adjacent two pixel repetition unit rows in the row direction;
the sub-pixels in any one pixel repetition unit row are staggered relative to the sub-pixels in another pixel repetition unit row adjacent to the any one pixel repetition unit row in the row direction; and
a light splitting assembly, positioned on a display side of the display panel and including a plurality of light splitting repetition units which extend in the column direction and are consecutively arranged in the row direction, wherein each of the light splitting repetition units include M light splitting structures which extend in the column direction and are consecutively arranged in the row direction, and each light splitting repetition unit corresponds to N columns of the sub-pixels in each pixel repetition unit row, where each of M and N is an integer greater than 1, and M is coprime with N.

In some embodiments, the plurality of pixel repetition unit rows are divided into a plurality of pixel repetition unit groups, and each of the pixel repetition unit groups includes M pixel repetition unit rows; in each pixel repetition unit group, the sub-pixels in one pixel repetition unit row of any adjacent two pixel repetition unit rows are staggered relative to the sub-pixels in the other pixel repetition unit row of the adjacent two pixel repetition unit rows in the row direction; each pixel repetition unit group includes subunits in one-to-one correspondence with the plurality of light splitting repetition units; and
in each subunit, a ratio $J_j$ of a staggered vector by which a c-th sub-pixel in a j-th pixel repetition unit row is staggered relative to the c-th sub-pixel in a first pixel repetition unit row in the row direction to a width of each sub-pixel in the row direction satisfies $J_j = \pm E/M$, where c is an integer greater than or equal to 1 and less than or equal to N, j is an integer greater than 1 and less than or equal to M, and E is an integer greater than or equal to 1, not equal to M, and not equal to an integer multiple of M.

In some embodiments, in a 2-nd to an M-th pixel repetition unit rows in each subunit, $J_j$ corresponding to any two pixel repetition unit rows is not equal to each other, and an absolute value of a difference between $J_j$ corresponding to any two pixel repetition unit rows is not an integer greater than or equal to 1.

In some embodiments, for the pair of adjacent two pixel repetition unit rows of at least some of pairs of adjacent two pixel repetition unit rows in each subunit, a ratio $\Delta J$ of a staggered vector by which the c-th sub-pixel in one pixel repetition unit row is staggered relative to the c-th sub-pixel in the other pixel repetition unit row in the row direction to the width of each sub-pixel in the row direction is not equal to $\pm C\dfrac{1}{M}$ or $\pm C\dfrac{M-1}{M}$ , where C is an integer greater than 0.

In some embodiments, E is an integer greater than or equal to 1 and less than or equal to M-1.

In some embodiments, for the pair of adjacent two pixel repetition unit rows of at least some of pairs of adjacent two pixel repetition unit rows in each subunit, a ratio $\Delta J$ of a staggered vector by which the c-th sub-pixel in one pixel repetition unit row is staggered relative to the c-th sub-pixel in the other pixel repetition unit row in the row direction to the width of each sub-pixel in the row direction is not equal to $\pm$ 1/M or $\pm$ (M-1)/M.

In some embodiments, the sub-pixels in different subunits in a same pixel repetition unit row in each pixel repetition unit group have a same staggered vector.

In some embodiments, each light splitting repetition unit corresponds to K columns of pixel islands in each pixel repetition unit row, where K is an integer greater than 1.

In some embodiments, N is coprime with K.

In some embodiments, N/K is an integer.

In some embodiments, each of the pixel islands includes n sub-pixels arranged to be spaced apart from each other in the row direction, where n is an integer greater than 1; each light splitting repetition unit corresponds to and covers K columns of pixel islands in at least part of pixel repetition unit rows, and N = K $\times$ n, where K is an integer greater than 1, and M is coprime with K.

In some embodiments, outgoing light emitted from light emitting regions of N columns of sub-pixels in each pixel repetition unit row and then split by M light splitting structures forms a continuous light emitting region in a space.

In some embodiments, in the horizontal direction, a width of M light splitting structures is equal to a width of N columns of sub-pixels.

In some embodiments, each sub-pixel includes a sub-pixel opening, and in the row direction, a ratio of a total width of n sub-pixel openings to a width of each pixel island is greater than or equal to 0.9/M and less than or equal to 1.

In some embodiments, in the row direction, the light emitting regions of N columns of sub-pixels in each pixel repetition unit row are complementarily spliced together in the space.

In some embodiments, in the row direction, a ratio of a width of each sub-pixel opening to the width of each pixel island is 1/M.

In some embodiments, in the row direction, the light emitting regions of N columns of sub-pixels in each pixel repetition unit row spatially overlap with each other.

In some embodiments, in the row direction, the light emitting regions of N columns of sub-pixels spatially overlap with each other uniformly.

In some embodiments, in the row direction, a ratio of a width of each sub-pixel opening to the width of each pixel island is i/M, where i is an integer greater than 1 and less than or equal to M-1.

In some embodiments, M is 5, J2 is -2/5 or 3/5, J3 is 115 or -4/5, J4 is -1/5 or 4/5, and J5 is 2/5 or -3/5.

In some embodiments, the display device further includes: a spacer dielectric layer positioned between the light splitting assembly and the display panel.

In some embodiments, each of the light splitting structures is one of a geometric lens, a diffractive lens, a liquid crystal lens, or a liquid lens.

In some embodiments, each of the pixel repetition units includes three pixel islands arranged consecutively in the column direction; and

in each pixel repetition unit, the sub-pixels of a same pixel island have a same display color, and the sub-pixels of different pixel islands have different display colors.

In some embodiments, the display device further includes:

an eye tracking system for determining a position of an eye of a user in real time.

## BRIEF DESCRIPTION OF THE DRAWINGS

To more clearly illustrate technical solutions according to embodiments of the present disclosure, the drawings accompanying the description of the embodiments will be briefly described below. It is apparent that the figures accompanying the description below are only some embodiments of the present disclosure, and it is obvious for one of ordinary skill in the art that other figures may be obtained according to the provided figures without inventive efforts, in which:

FIG. 1 is a schematic diagram illustrating a structure of a display device in the related art;

FIG. 2 is a schematic diagram of a relative brightness distribution according to an embodiment of the present disclosure;

FIG. 3 is a schematic diagram of a visual sensory distribution according to an embodiment of the present disclosure;

FIG. 4 is a schematic diagram illustrating a structure of a display device according to an embodiment of the present disclosure;

FIG. 5 is a schematic diagram of a relative brightness distribution of a subunit according to an embodiment of the present disclosure;

FIG. 6 is a schematic diagram of a visual sensory distribution of a subunit according to an embodiment of the present disclosure;

FIG. 7 is a schematic diagram of a visual sensory distribution of a plurality of subunits according to an embodiment of the present disclosure;

FIG. 8 is a schematic diagram illustrating light paths of light output from sub-pixels of a display device according to an embodiment of the present disclosure;

FIG. 9 is a schematic diagram illustrating light paths of light output from sub-pixels, which have been spliced together, of a display device according to an embodiment of the present disclosure;

FIG. 10 is a schematic diagram illustrating light paths of light output from sub-pixels of another display device according to an embodiment of the present disclosure;

FIG. 11 is a schematic diagram illustrating light paths of light output from sub-pixels, which have been spliced together, of another display device according to an embodiment of the present disclosure; and

FIG. 12 is a schematic diagram illustrating a structure of another display device according to an embodiment of the present disclosure.

DETAILED DESCRIPTION OF EMBODIMENTS

To make the objects, technical solutions and advantages of the embodiments of the present disclosure more apparent, the technical solutions of the embodiments of the present disclosure will be clearly and completely described below with reference to the drawings accompanying the embodiments of the present disclosure. It is to be understood that the described embodiments are only a few, but not all, embodiments of the present disclosure. The embodiments and features of the embodiments of the present disclosure may be combined with each other in case of no conflict. All other embodiments, which may be derived by one of ordinary skill in the art from the described embodiments of the present disclosure without inventive step, are within the protection scope of the present disclosure.

Unless defined otherwise, technical or scientific terms used herein shall have the ordinary meaning as understood by one of ordinary skill in the art to which this disclosure belongs. The use of "first", "second," and the like in this disclosure is not intended to indicate any order, quantity, or importance, but rather is used for distinguishing one element from another. The word "include", "comprise", or the like, means that the element or item preceding the word contains the element or item listed after the word and its equivalent, but does not exclude the presence of other elements or items. The term "connected", "coupled", or the like is not limited to physical or mechanical connections, but may include electrical connections, whether direct or indirect.

It should be noted that the sizes and shapes of the various components in the drawings are not necessarily to scale, but are merely intended to schematically illustrate the present disclosure. Further, like reference numerals refer to like or similar elements or elements having like or similar functions throughout the drawings.

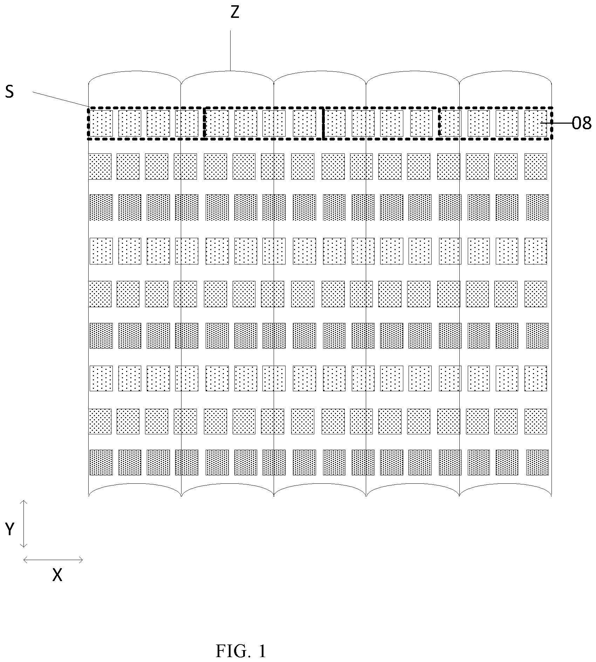

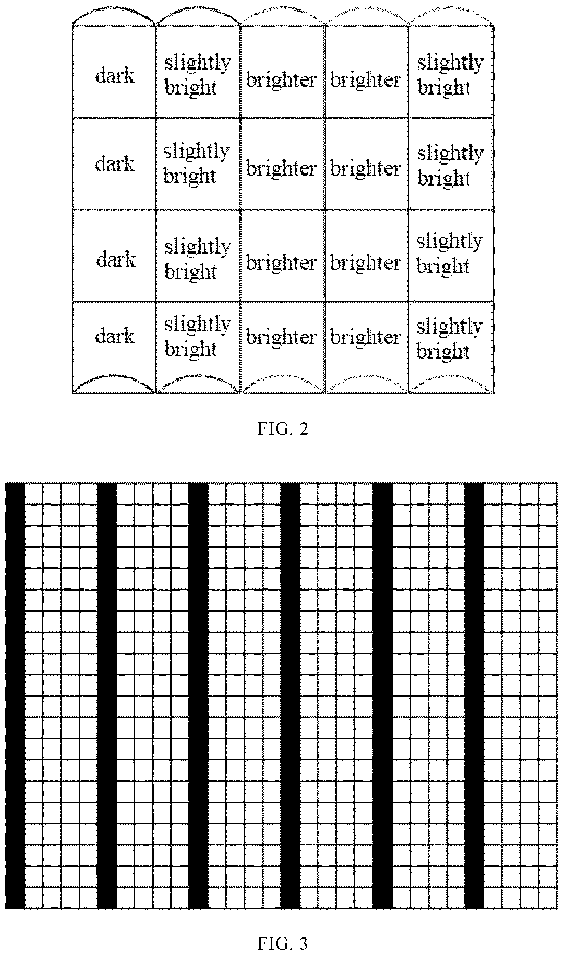

In the related art, as shown in FIG. 1, a display device includes a plurality of pixel islands S arranged to be spaced apart from each other in a row direction X and a column direction Y, and a plurality of cylindrical lenses Z. Each pixel island S has a plurality of sub-pixels 08 arranged to be spaced apart from each other in the row direction X. The M cylindrical lenses Z correspond to and cover N columns of sub-pixels, such that a problem of macroscopic Moire fringes is solved, but a problem of microscopic Moire fringes occurs. In a unit with M = 5 as a period, a brightness of a region corresponding to each cylindrical lens is different at different viewing angles in a space, and the brightnesses of regions corresponding to the 5 cylindrical lenses seen at any viewing angle are different from each other. A relative brightness distribution of the 5 regions seen at one viewing angle is as shown in FIG. 2, and a visual sensory effect perceived by a person is as shown in FIG. 3, where one of the 5 regions has the lowest brightness, called a dark region. Dark regions connected to each other form a thin stripe, and thin stripes have a large distance (which is about 727.2 μm) therebetween and therefore are easily recognized by human eyes, resulting in that the display device has the problem of microscopic Moire fringes.

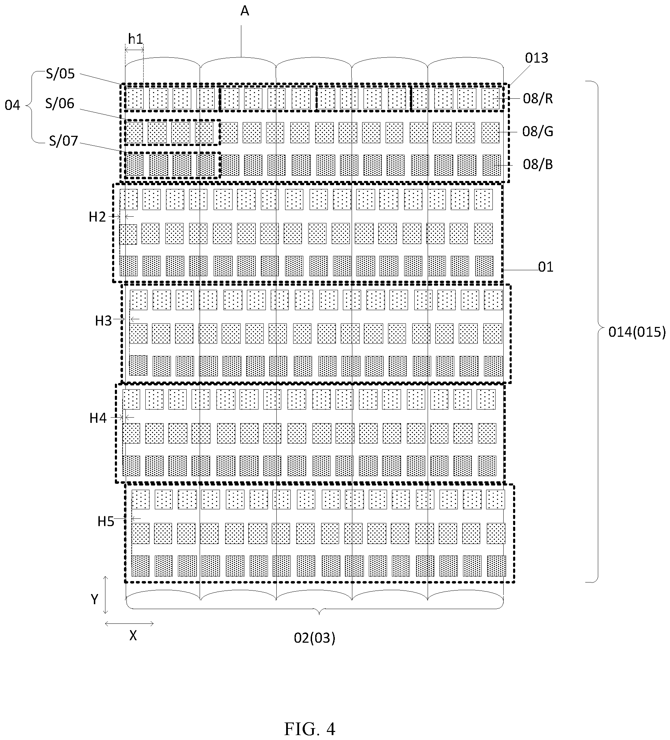

An embodiment of the present disclosure provides a display device. As shown in FIG. 4, the display device includes a display panel 01 and a light splitting assembly 02.

The display panel 01 includes a plurality of pixel repetition units 04 arranged in an array along a row direction X and a column direction Y. Each pixel repetition unit 04 includes a plurality of pixel islands S arranged consecutively in the column direction. Each pixel island S includes a plurality of sub-pixels 08 arranged to be spaced apart from each other in the row direction X. The plurality of pixel repetition units 04 include a plurality of pixel repetition unit rows 013 arranged in the column direction Y. For any adjacent two pixel repetition unit rows 013, sub-pixels 08 in one pixel repetition unit row 013 are staggered (or misaligned) relative to sub-pixels 08 in the other pixel repetition unit row 013 in the row direction X.

The light splitting assembly 02 is positioned on a display side of the display panel 01, and includes a plurality of light splitting repetition units 03 extending in the column direction Y and arranged consecutively in the row direction X. Each of the light splitting repetition units 03 includes M light splitting structures A extending in the column direction Y and arranged consecutively in the row direction X. Each light splitting repetition unit 03 corresponds to N columns of sub-pixels in each pixel repetition unit row, where each of M and N is an integer greater than 1, and M is coprime with N.

It should be noted that, the expression "for any adjacent two pixel repetition unit rows, sub-pixels in one pixel repetition unit row are staggered relative to sub-pixels in the other pixel repetition unit row in the row direction" means that centers of the sub-pixels in the adjacent two pixel repetition unit rows are not on a straight line in the column direction.

In the display device according to the present embodiment, the M light splitting structures correspond to N columns of sub-pixels in each pixel repetition unit row, and each of M and N is an integer greater than 1. That is, the light splitting structures are in a many-to-many correspondence with the sub-pixels. As such, it can be avoided that each light splitting structure has a too small size in the row direction, it can be avoided that the difficulty for manufacturing the light splitting assembly is increased, and it can be avoided that a divergence angle of light output from the sub-pixels being increased, crosstalk between views being increased, and the display effect being affected, are caused by the diffraction of each light splitting structure with a too small size. Further, since in at least some adjacent two pixel repetition unit rows, the sub-pixels in one pixel repetition unit row are staggered relative to the sub-pixels in another pixel repetition unit row adjacent to the one pixel repetition unit row in the row direction, such that the distribution of the dark regions corresponding to the light splitting repetition units can be disturbed, to make the dark regions arranged in a staggered manner, thereby preventing the dark regions from forming thin stripes continuously in the column direction, and mitigating the problem of microscopic Moire fringes.

It should be noted that, the expression that each light splitting repetition unit corresponds to N columns of sub-pixels in each pixel repetition unit row means that, an orthogonal projection of each light splitting repetition unit on a plane where the display panel is located overlaps with an orthogonal projection of the N columns of sub-pixels in each pixel repetition unit row on the plane where the display panel is located. Since for any adjacent two pixel repetition unit rows, sub-pixels in one pixel repetition unit row are staggered relative to sub-pixels in the other pixel repetition unit row in the row direction X, for example, for a part of pixel repetition unit rows, the orthogonal projection of the light splitting repetition unit on the plane where the display panel is located completely covers the orthogonal projection of the N columns of sub-pixels in the part of pixel repetition unit rows on the plane where the display panel is located; for the remaining pixel repetition unit rows, the orthogonal projection of the light splitting repetition unit on the plane where the display panel is located does not completely cover the orthogonal projection of the N columns of sub-pixels in the remaining pixel repetition unit rows on the plane where the display panel is located, i.e., for the sub-pixels located at an edge of the light splitting repetition unit, the orthogonal projection of the light splitting repetition unit on the plane where the display panel is located only covers a part of the orthogonal projection of these sub-pixels on the plane where the display panel is located.

In some embodiments, as shown in FIG. 4, the sub-pixels 08 in one pixel repetition unit row 013 are staggered relative to the sub-pixels 08 in another pixel repetition unit row 013 adjacent to the one pixel repetition unit row 013 in the row direction X. Therefore, there are no dark regions adjacent to each other in the column direction, thereby avoiding a thin stripe formed by continuous dark regions in the column direction, and effectively solving the problem of microscopic Moire fringes.

It should be noted that, the display device according to an embodiment of the present disclosure may implement three-dimensional (3D) display, and may also switch between 3D display and 2D display. Each pixel island may serve as a sub-pixel of 2D display. Since each pixel island includes a plurality of sub-pixels, a resolution in a 3D display mode may be kept to be the same as a resolution in a 2D display mode, and by being combined with an eye-tracking system, multi-view display with a large viewing angle and 3D display with higher pixel density (PPI) may be achieved, such that an information amount is large, and a color crosstalk between adjacent views is low.

In a specific implementation, the light splitting structures are configured to control a light outgoing angle of the sub-pixels, such that the sub-pixels emit light directionally.

In a specific implementation, the display panel may be one of a liquid crystal display (LCD) panel, an organic light emitting diode (OLED) display panel, a quantum dot light emitting diode (QLED), a micro inorganic light emitting diode (micro LED) display panel, or a mini light emitting diode (mini LED) display panel.

In some embodiments, as shown in FIG. 4, each pixel repetition unit 04 includes three pixel islands S arranged consecutively in the column direction Y; and in each pixel repetition unit 04, the sub-pixels 08 of a same pixel island S have a same display color, and the sub-pixels 08 of different pixel islands S have different display colors.

In some embodiments, as shown in FIG. 4, each pixel repetition unit 04 includes a first pixel island 05, a second pixel island 06, and a third pixel island 07. The first pixel island 05 includes a plurality of red sub-pixels R, the second pixel island 06 includes a plurality of green sub-pixels G, and the third pixel island 07 includes a plurality of blue sub-pixels B.

In some embodiments, as shown in FIG. 4, the sub-pixels 08 in a row of pixel islands S has a same display color.

In some embodiments, as shown in FIG. 4, the plurality of pixel repetition unit rows 013 are divided into a plurality of pixel repetition unit groups 014, and each pixel repetition unit group 014 includes M pixel repetition unit rows 013. In each pixel repetition unit group 014, the sub-pixels 08 in one pixel repetition unit row 013 are staggered relative to the sub-pixels 08 in another pixel repetition unit row 013 adjacent to the one pixel repetition unit row 013 in the row direction X. Each pixel repetition unit group 014 is divided into a plurality of subunits 015 in one-to-one correspondence with the light splitting repetition units 03, i.e., a portion, which corresponds to the M light splitting structures, of each pixel repetition unit group 014 is one subunit 015.

It should be noted that in FIG. 4, M = 5, i.e., each pixel repetition unit group 014 includes 5 pixel repetition unit rows 013, and only one subunit 015, i.e. only the part of each pixel repetition unit group 014 corresponding to the 5 light splitting structures A, is shown in FIG. 4.

In some embodiments, as shown in FIG. 4, in each subunit, a ratio $J_j$ of a staggered vector $H_j$ by which a c-th sub-pixel 08 in a j-th pixel repetition unit row 013 is staggered relative to the c-th sub-pixel 08 in a first pixel repetition unit row 013 in the row direction X to a width $h1$ of each sub-pixel in the row direction X satisfies $J_j = \pm E/M$, where c is an integer greater than or equal to 1 and less than or equal to N, j is an integer greater than 1 and less than or equal to M, and E is an integer greater than or equal to 1, not equal to M, and not equal to an integer multiple of M.

That is, in the present embodiment, in each subunit, each sub-pixel in each of a 2-nd pixel repetition unit row to an M-th pixel repetition unit row is staggered relative to a corresponding sub-pixel in the first pixel repetition unit row by $Jj \times h1$.

It should be noted that, the row direction X shown in FIG. 4 is a left-right extension direction in the figure. In a case where a sub-pixel 08 in the j-th pixel repetition unit row 013 is staggered to the left relative to a corresponding sub-pixel 08 in the first pixel repetition unit row 013, Hj is positive, and $Jj = + E/M$. In a case where a sub-pixel 08 in the j-th pixel repetition unit row 013 is staggered to the right relative to the corresponding sub-pixel 08 in the first pixel repetition unit row 013, Hj is negative, and $Jj = - E/M$.

In some embodiments, in each pixel repetition unit group, the sub-pixels of different subunits in a same pixel repetition unit row have a same staggered vector. That is, in each pixel repetition unit group, for the M pixel repetition unit rows 013, the ratio Jj of the staggered vector Hj by which a sub-pixel in the j-th pixel repetition unit row is staggered relative to a corresponding sub-pixel in the first pixel repetition unit row in the row direction to the width h1 of each sub-pixel in the row direction X satisfies $Jj = \pm E/M$.

It should be noted that, a relative brightness distribution of a region of each subunit corresponding to the M light splitting structures may be divided into M × M bright regions. For each subunit, in the case where each sub-pixel in each of the 2-nd pixel repetition unit row to the M-th pixel repetition unit row is staggered relative to a corresponding sub-pixel in the first pixel repetition unit row, a dark region with the lowest brightness in bright regions corresponding to the 2-nd to M-th pixel repetition unit rows is staggered relative to a dark region corresponding to the first pixel repetition unit row, such that a distribution of dark regions among the regions corresponding to the subunits can be disturbed, and the dark regions are staggered. Further, since the display panel includes a plurality of pixel repetition unit groups that include a plurality of subunits, each of the subunits serves as the minimum unit disturbing the distribution of dark regions. Since the distribution of the dark regions of each subunit is disturbed in the column direction, a thin stripe formed by the dark regions consecutively in the column direction for the whole display device can be avoided, and the problem of microscopic Moire fringes is solved.

In a specific implementation, M = 5, and in this case, Jj may be -11/5, -6/5, -4/5, -3/5, -2/5, -115, 115, 2/5, 3/5, 4/5, 6/5, 11/5, or the like.

It should be noted that in a case where a difference between two values (e.g., -6/5 and -115) of Jj is M or an integer multiple of M, the number of bright regions between the dark region of a current row and the dark region of the first row when Jj is -6/5 is the same as the number of the bright regions between the dark region of the current row and the dark region of the first row when Jj is -1/5.

In some embodiments, in the 2-nd to the M-th pixel repetition unit rows in each subunit, Jj corresponding to any two pixel repetition unit rows is not equal to each other, and an absolute value of a difference between Jj corresponding to any two pixel repetition unit rows is not an integer greater than or equal to 1. Thus, in each pixel repetition unit group, the dark regions are not positioned in a same column in the column direction, such that a distance between two dark regions arranged in the column direction can be increased, and a thin stripe which is easily perceived by human eyes in the column direction is avoided.

In some embodiments, for each of at least some of pairs of adjacent two pixel repetition unit rows in each subunit, a ratio ∆J of a staggered vector by which a c-th sub-pixel in one pixel repetition unit row is staggered relative to the c-th sub-pixel in the other pixel repetition unit row in the row direction to the width of each sub-pixel in the row direction is not equal to $\pm C\frac{1}{M}$ or $\pm C\frac{M-1}{M}$, where C is an integer greater than 0. As such, any adjacent two dark regions in each pair of adjacent two pixel repetition unit rows have at least one bright region therebetween, thereby avoiding continuous dark regions, effectively preventing human eye from perceiving a thin stripe extending in an inclined direction, and effectively solving the problem of microscopic Moire fringes.

In some embodiments, E is an integer greater than or equal to 1 and less than or equal to M-1. That is, a staggered vector between the sub-pixels does not exceed the width of one sub-pixel in the row direction X. As such, the distribution of dark regions corresponding to the subunits can be disturbed, while a staggered distance between the sub-pixels is prevented from being too large, thereby effectively utilizing a space of the display panel.

It should be noted that, in the case where M = 5 and E is an integer greater than or equal to 1 and less than or equal to M-1, Jj may be one of the following: -4/5, -3/5, -2/5, -115, 115, 2/5, 3/5, and 4/5. In the case where Jj is -4/5, the dark region corresponding to the current row is staggered to the right by 4 bright regions relative to the dark region corresponding to the first row (i.e., the dark region corresponding to the current row is separated from the dark region corresponding to the first row by 3 bright regions). In a case where Jj is -3/5, the dark region corresponding to the current row is staggered to the right by 3 bright regions relative to the dark region corresponding to the first row (i.e., the dark region corresponding to the current row is separated from the dark region corresponding to the first row by 2 bright regions). In a case where Jj is -2/5, the dark region corresponding to the current row is staggered to the right by 2 bright regions relative to the dark region corresponding to the first row (i.e., the dark region corresponding to the current row is separated from the dark region corresponding to the first row by 1 bright region). In a case where Jj is -115, the dark region corresponding to the current row is staggered to the right by 1 bright region relative to the dark region corresponding to the first row (i.e., the dark region corresponding to the current row is separated from the dark region corresponding to the first row by 0 bright regions). In a case where Jj is 115, the dark region corresponding to the current row is staggered to the left by 1 bright region relative to the dark region corresponding to the first row (i.e., the dark region corresponding to the current row is separated from the dark region corresponding to the first row by 0 bright regions). In a case where Jj is 2/5, the dark region corresponding to the current row is staggered to the left by 2 bright regions relative to the dark region corresponding to the first row (i.e., the dark region corresponding to the current row is separated from the dark region corresponding to the first row by 1 bright region). In a case where Jj is 3/5, the dark region corresponding to the current row is staggered to the left by 3 bright regions relative to the dark region corresponding to the first row (i.e., the dark region corresponding to the current row is separated from the dark region corresponding to the first row by 2 bright regions). In a case where Jj is 4/5, the dark region corresponding to the current row is staggered to the left by 4 bright regions relative to the dark region corresponding to the first row (i.e., the dark region corresponding to the current row is separated from the dark region corresponding to the first row by 3 bright regions).

In some embodiments, in the case where M is 5, J2 is -2/5 or 3/5, J3 is 115 or -4/5, J4 is -1/5 or 4/5, and J5 is 2/5 or -3/5.

In a specific implementation, for example, J2 is -2/5, J3 is 115, J4 is -115, J5 is 2/5, and accordingly, as shown in FIG. 4, H2 = (-2/5)h1, H3 = (1/5)h1, H4 = (-1/5)hl, and H5 = (2/5)h1.

Alternatively, in a specific implementation, J2 may be 3/5, J3 may be -4/5, J4 may be 4/5, and J5 may be -3/5.

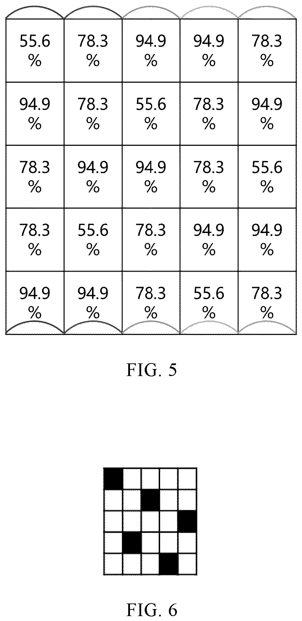

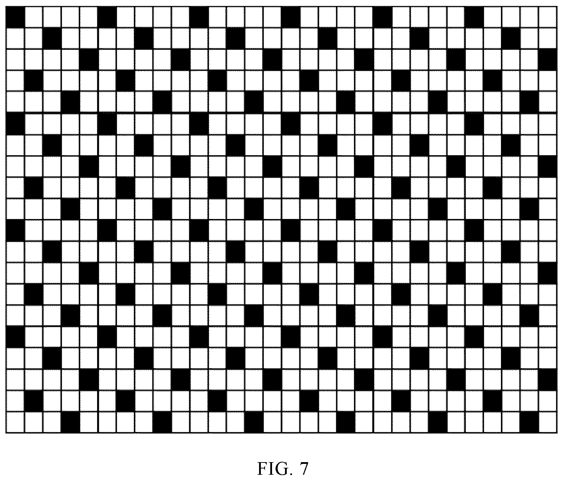

In a specific implementation, in the case where M = 5, J2 is -2/5, J3 is 115, J4 is -115, and J5 is 2/5, the relative brightness distribution of the region of each subunit corresponding to 5 light splitting structures is as shown in FIG. 5, and may be divided into $5 \times 5$ bright regions, in which a region corresponding to the relative brightness of 55.6% is a dark region. The visual sensory effect of the region of each subunit shown in FIG. 5 is shown in FIG. 6, in which the dark regions of different rows are not in a same column, i.e. the dark regions of different rows are staggered relative to each other, and the visual sensory effect of the regions of a plurality of subunits is as shown in FIG. 7.

It should be noted that, although dark-region thin stripes are formed when dark regions are connected together as shown in FIG. 7, each of the dark-region thin stripes extends in a direction (hereinafter referred to as an inclined direction) having an angle greater than 0 with respect to each of the row direction and the column direction, and a distance between any two of the dark-region thin stripes extending in the inclined direction is 391.6 $\mu$m, which is much smaller than a distance (of 727.2 $\mu$m) between any two of the dark-region thin stripes extending in the column direction in the related art. For the distance of 391.6 microns, the dark-region thin stripes are not easy to be perceived at an observation distance of 300 mm, but in the normal case, the observation distance when a user uses the display device is usually 630 mm, at such an observation distance, the existence of the thin stripes extending in the inclined direction is not easy perceived by human eyes, thereby effectively solving the problem of microscopic Moire fringes.

In some embodiments, in a case where E is an integer greater than or equal to 1 and less than or equal to M-1, Jj for any two pixel repetition unit rows among the 2-nd to M-th pixel repetition unit rows in each subunit is not equal to each other, and in a case where one of Jj corresponding to two pixel repetition unit rows is positive (+) and the other is negative (-), a sum of the absolute values of the Jj corresponding to the two pixel repetition unit rows is not equal to 1. Thus, in each pixel repetition unit group, the dark regions are not positioned in a same column in the column direction, thereby increasing a distance between any two dark regions arranged in the column direction, and avoiding a thin stripe which is easily perceived by human eyes in the column direction.

In some embodiments, as shown in FIGS. 5 and 6, a line connecting centers of the dark regions in the bright region corresponding to each subunit is not on a same straight line. That is, in the bright region corresponding to each subunit, the dark regions are not sequentially arranged along a direction (which also referred to as the inclined direction) having an angle greater than 0 with respect to each of the row direction and the column direction, but are distributed on a plurality of straight lines extending along the inclined direction. Therefore, compared with the case where the line connecting the centers of the dark regions is on a same straight line, a distance between any two dark-region thin stripes in the whole display device as shown in FIG. 7 is small, such that the existence of the thin stripes extending in the inclined direction is not easy to be perceived by human eyes, and the problem of microscopic Moire fringes is effectively solved.

In some embodiments, in a case where E is an integer greater than or equal to 1 and less than or equal to M-1, for each of at least some of pairs of adjacent two pixel repetition unit rows in each subunit, a ratio ΔJ of a staggered vector by which a c-th sub-pixel in one pixel repetition unit row is staggered relative to the c-th sub-pixel in the other pixel repetition unit row in the row direction to the width of each sub-pixel in the row direction is not equal to $\pm 1/M$ or $\pm(M-1)/M$. As such, any adjacent two dark regions in each pair of adjacent two pixel repetition unit rows have at least one bright region therebetween, thereby avoiding continuous dark regions, effectively preventing human eyes from perceiving a thin stripe extending in the inclined direction, and effectively solving the problem of microscopic Moire fringes.

In some embodiments, each light splitting repetition unit corresponds to K columns of pixel islands in each pixel repetition unit row, where K is an integer greater than 1.

In the display device according to the present embodiment, each light splitting repetition unit corresponds to K columns of pixel islands in each pixel repetition unit row, i.e., M light splitting structures correspond to K columns of pixel islands in each pixel repetition unit row, where each of M and K is an integer greater than 1. That is, the light splitting structures are in many-to-many correspondence with pixel island columns. As such, it can be avoided that each light splitting structure has a too small size in the row direction, it can be avoided that the difficulty for manufacturing the light splitting assembly is increased, and it can be avoided that a divergence angle of light output from the sub-pixels being increased, the crosstalk between views being increased, and the display effect being affected, are caused by the diffraction of each light splitting structure with a too small size.

In some embodiments, N/K is an integer. That is, N columns of sub-pixels in each pixel repetition unit row and corresponding to the M light splitting structures can be equally divided into a plurality of columns of pixel islands.

In a specific implementation, as shown in FIG. 4, each pixel island S includes n sub-pixels 08 arranged to be spaced apart from each other in the row direction X, where n is an integer greater than 1; and each light splitting repetition unit corresponds to K columns of pixel islands in each pixel repetition unit row, where N = K × n, k is an integer greater than 1, and M is coprime with K.

Alternatively, in some embodiments, N is coprime with K. That is, the N columns of sub-pixels in each pixel repetition unit row and corresponding to the M light splitting structures cannot be equally divided into a plurality of columns of pixel islands.

In a specific implementation, even if N columns of sub-pixels in each pixel repetition unit row and corresponding to the M light splitting structures cannot be equally divided into a plurality of columns of pixel islands, the light splitting structures are still in many-to-many correspondence with the pixel islands, it can also be avoided that each light splitting structure has a too small size in the row direction, it can also be avoided that the difficulty for manufacturing the light splitting assembly is increased, and it can also be avoided that a divergence angle of light output from the sub-pixels being increased, crosstalk between views being increased, and the display effect being affected, are caused by the diffraction of each light splitting structure with a too small size.

In some embodiments, in a horizontal direction, a width of the M light splitting structures is equal to a width of the N columns of sub-pixels in each pixel repetition unit row.

In some embodiments, light emitting regions of the N columns of sub-pixels in each pixel repetition unit row are subjected to light splitting by the M light splitting structures, and then the emitted light forms continuous light emitting regions in the space.

In the display device according to the present embodiment, N columns of sub-pixels correspond to M light splitting structures, and light emitting regions of the sub-pixels in the N columns of sub-pixels are spatially staggered. Further, since each light splitting structure has a small size in the row direction, for N columns of sub-pixels corresponding to M light splitting structures, human eyes cannot distinguish which of light splitting structures light exits from, such that the human eyes can see that the light emitted from the N columns of sub-pixels and then being split by the M light splitting structures above the N columns of sub-pixels forms a continuous light emitting region in a space, and the human eyes cannot see a "black region" when moving in a visible space.

In some embodiments, each of the sub-pixels includes a sub-pixel opening (i.e., an opening of the sub-pixel), and in the row direction, a ratio of a total width of n sub-pixel openings to a width of each pixel island is greater than or equal to 0.9/M and less than or equal to 1. That is, an aperture ratio of the sub-pixels in each pixel island is greater than or equal to 0.9/M and less than or equal to 1.

In some embodiments, in the row direction, the light emitting regions of the N columns of sub-pixels in each pixel repetition unit row are spatially complementarily spliced together.

In some embodiments, a ratio of a width of each sub-pixel opening to the width of each pixel island in the row direction is 1/M. That is, an aperture ratio of each sub-pixel in each pixel island is 1/M. With such a configuration, the sub-pixels below each light splitting repetition unit are staggered and complementarily arranged relative to positions of the corresponding light splitting structures, such that the light emitting regions of N columns of sub-pixels are spatially complementarily spliced together, i.e., light paths of views (or viewpoints) are closely connected together, thereby mitigating the problem of macroscopic Moire fringes, and improving the display effect.

In some embodiments, in the row direction, the light emitting regions of the N columns of sub-pixels in each pixel repetition unit row spatially overlap with each other.

In some embodiments, in the row direction, the light emitting regions of the N columns of sub-pixels in each pixel repetition unit row overlap with each other uniformly in a space (i.e., overlap with each other uniformly and spatially).

In some embodiments, in the row direction, a ratio of the width of the sub-pixel opening to the width of each pixel island is i/M, where i is an integer greater than 1 and less than or equal to M-1.

It should be noted that, in the display device according to the present embodiment, M light splitting structures correspond to N columns of sub-pixels in each pixel repetition unit row, and correspond to K pixel islands in each pixel repetition unit row. That is, the sub-pixels are in many-to-many correspondence with the light splitting structures, and meanwhile, the pixel islands are in many-to-many correspondence with the light splitting structures. In the case where in the row direction, a width of M light splitting structures is equal to a width of N columns of sub-pixels in each pixel repetition unit row, even if the number of light splitting structures is increased, a size of each light splitting structure will not be too small in the row direction, and thus it is not difficult to manufacture the light splitting structures. Further, in the case where an aperture ratio of a sub-pixel is i/M, i being an integer greater than 1 and less than or equal to M-1, the aperture ratio of the sub-pixel can be increased when the number of light splitting structures is constant as compared to the case where a pixel island is in one-to-many correspondence with light splitting structures.

In a specific implementation, in a case where each light splitting repetition unit corresponds to K columns of pixel islands and N = K × n, the width of N columns of sub-pixels is the width of the K columns of pixel islands, and in the horizontal direction, the width of M light splitting structures is equal to the width of the K columns of pixel islands.

In a specific implementation, in the case where each light splitting repetition unit corresponds to K columns of pixel islands and N = K × n, the light emitting regions of the sub-pixels in the K pixel islands are staggered in a space (or spatially), such that the outgoing light emitted from the sub-pixels in the K pixel islands and having being split by the M light splitting structures forms a continuous light emitting region in a space.

It should be noted that, the space in the expression "the light emitting regions of the sub-pixels in the K pixel islands are staggered in a space" refers to a visible space of the display device.

In the display device according to the present embodiment, K pixel islands correspond to M light splitting structures, and the light emitting regions of the sub-pixels in the K pixel islands are staggered in the space. Since each light splitting structure has a small size in the row direction, for the K pixel islands covered by the M light splitting structures, human eyes cannot recognize which of the light splitting structures light emits from, such that the outgoing light emitted from the K pixel islands and then being split by the M light splitting structures located above the K pixel islands forms a continuous light emitting region in the space, and the human eyes cannot see a "black region" when moving in a visible space.

It should be noted that, a viewing angle includes a main lobe viewing angle and a side lobe viewing angle. The main lobe viewing angle refers to a viewing angle formed in a space after light emitted from the sub-pixels is split by the light splitting structure right above the sub-pixels. The side lobe viewing angle refers to a viewing angle formed in a space after light emitted from the sub-pixels is split by a light splitting structure beside the light splitting structure right above the sub-pixels, for example, a first-level side lobe viewing angle formed in a space after light emitted from the sub-pixels is split by a first light splitting structure adjacent to the light splitting structure right above the sub-pixels, a second-level side lobe viewing angle formed in a space after light emitted from the sub-pixels is split by a second light splitting structure adjacent to the light splitting structure right above the sub-pixels, and so on.

For better understanding of the present technical solution, a case where the main lobe viewing angle is adopted, and where each light splitting repetition unit corresponds to K columns of pixel islands and N = K × n is taken as an example, to exemplarily describe an example that the light emitting regions of the sub-pixels in the K pixel islands are staggered in a space, and that the outgoing light from the light emitting regions of the sub-pixels in the K pixel islands and then being split by the M light splitting structures forms a continuous light emitting region in the space.

In a specific implementation, in the M light splitting structures arranged in the row direction, a difference between the views (or viewpoints) of any adjacent two of the sub-pixels corresponding to each light splitting structure is M.

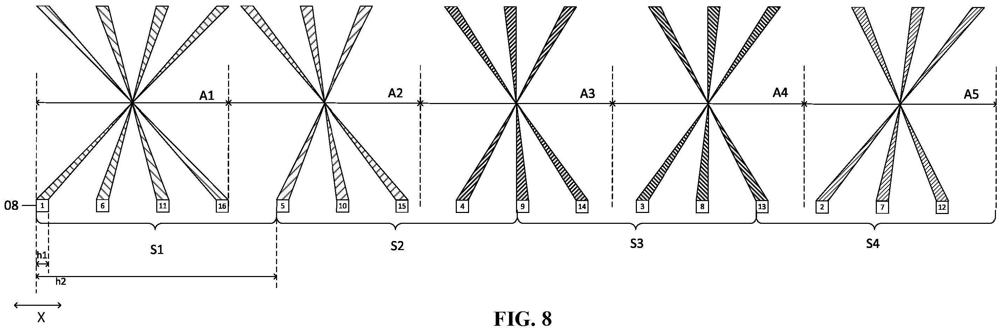

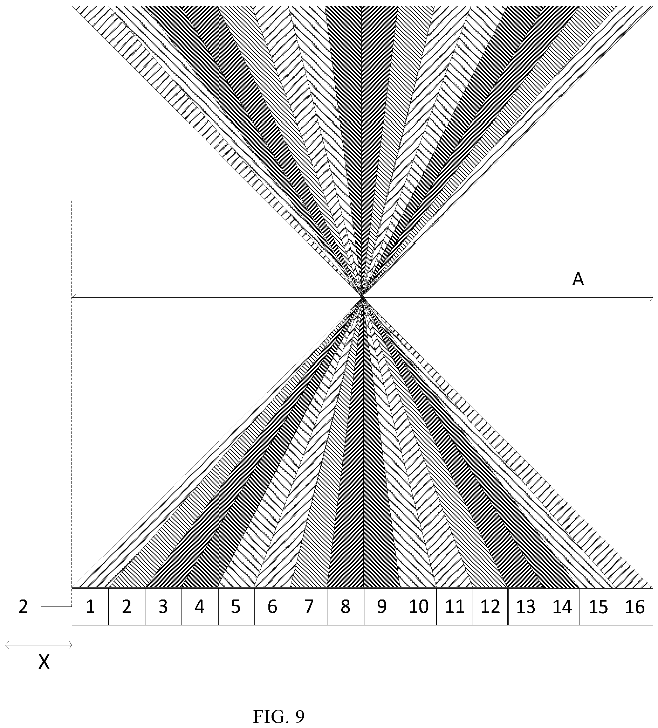

In some embodiments, K is 4, M is 5, n is 4, the aperture ratio of a sub-pixel is 1/5, and the light paths of the K columns of pixel islands are shown in FIGS. 8 and 9. Each row of 4 columns of pixel islands in each pixel repetition unit row corresponding to the 5 light splitting structures includes 16 sub-pixels which are respectively marked as a first sub-pixel 1 to a sixteenth sub-pixel 16, and the serial numbers of the sub-pixels represent the respective views (or viewpoints). The 4 pixel islands are a first pixel island S1, a second pixel island S2, a third pixel island S3 and a fourth pixel island S4. The first pixel island S1 includes the first sub-pixel 1, the sixth sub-pixel 6, the eleventh sub-pixel 11, and the sixteenth sub-pixel 16. The second pixel island S2 includes the fifth sub-pixel 5, the tenth sub-pixel 10, the fifteenth sub-pixel 15, and the fourth sub-pixel 4. The third pixel island S3 includes the ninth sub-pixel 9, the fourteenth sub-pixel 14, the third sub-pixel 3, and the eighth sub-pixel 8. The fourth pixel island S4 includes the thirteenth sub-pixel 13, the second sub-pixel 2, the seventh sub-pixel 7, and the twelfth sub-pixel 12. The light splitting structures corresponding to the 16 sub-pixels are marked as a first light splitting structure A1 to a fifth light splitting structure A5. As shown in FIG. 8, the first light splitting structure A1 covers the first sub-pixel 1, the sixth sub-pixel 6, the eleventh sub-pixel 11, and the sixteenth sub-pixel 16; the second light splitting structure A2 covers the fifth sub-pixel 5, the tenth sub-pixel 10, and the fifteenth sub-pixel 15; the third light splitting structure A3 covers the fourth sub-pixel 4, the ninth sub-pixel 9; and the fourteenth sub-pixel 14; the fourth light splitting structure A4 covers the third sub-pixel 3, the eighth sub-pixel 8, and the thirteenth sub-pixel 13; and the fifth light splitting structure A5 covers the second sub-pixel 2, the seventh sub-pixel 7, and the twelfth sub-pixel 12. As shown in FIG. 8, the relative positional relationship between each sub-pixel in the 4 pixel islands and the light splitting structures does not form a repetition unit. If the sub-pixels are sequentially spliced together according to a sequence of the views (or viewpoints), and the relative positions between the sub-pixels and the light splitting structures are kept unchanged, as shown in FIG. 9, after the sub-pixels corresponding to the light splitting structures are spliced together, the positions of the sub-pixels are complementary, i.e., a distance between any adjacent two of the sub-pixels is 0, the relative positional relationship between the sub-pixels and the light splitting structures forms a staggered and complementary arrangement. Accordingly, the light emitting regions of the sub-pixels in the 4 pixel islands are spatially staggered, and form a staggered and complementary arrangement. As shown in FIG. 8, since a gap exists between the first sub-pixel 1 and the fifth sub-pixel 5, light outgoing angles of light rays emitted from the adjacent sub-pixels corresponding to a same light splitting structure in the space after passing through the same light splitting structure A are discontinuous, but because the relative positions of the sub-pixels in the 4 pixel islands and the 5 light splitting structures A are in a staggered arrangement relationship, the light emitting regions of the sub-pixels in the 4 pixel islands are in a staggered arrangement in the space, and the light outgoing angles of the light splitting structures A are also staggered and complementary. Since the size of each light splitting structure A is very small, it cannot be distinguished for human eyes which of the light splitting structures A light emits from. As such, as shown in FIG. 9, the human eyes perceive that the outgoing light emitted from 16 sub-pixels in 4 pixel islands and then being split by 5 light splitting structures forms a continuous light emitting region in the space, and the human eyes cannot see a "black region" when moving in the space.

The continuity of the side lobe viewing angle is the same as the continuity of the main lobe viewing angle as described above, and two discontinuous first-level side lobe viewing angles of the K pixel islands through adjacent light splitting structures can complement each other to form a continuous first-level side lobe viewing angle. Further, in the horizontal direction, the width of the M light splitting structures is equal to the width of K columns of pixel islands in each pixel repetition unit row, such that a main lobe viewing angle boundary is parallel to a side lobe viewing angle boundary. Since human eyes cannot recognize a distance between the main lobe viewing angle boundary and the side lobe viewing angle boundary, the main lobe viewing angle and the side lobe viewing angle perceived by the human eyes are also continuous. Similarly, the first-level side lobe viewing angle and the second-level side lobe viewing angle are also continuous, the second-level side lobe viewing angle and a third-level side lobe viewing angle are also continuous, and so on. As such, a continuous viewing angle is obtained.

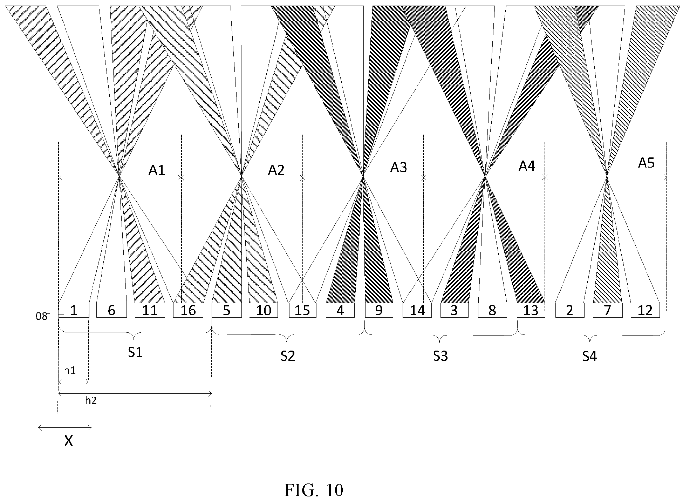

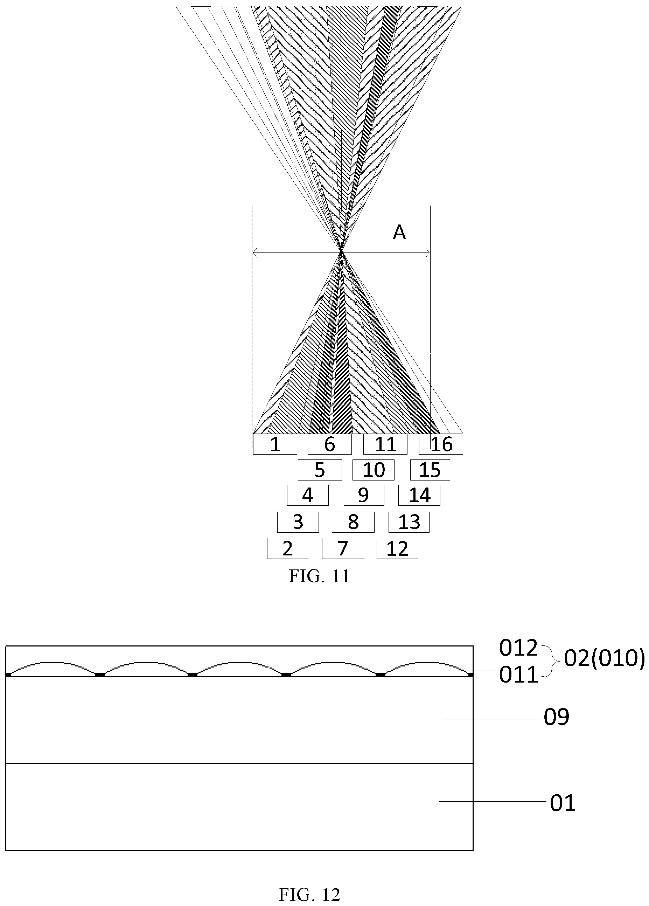

In some embodiments, K is 4, M is 5, n is 4, the aperture ratio of a sub-pixel is 4/5, and the light paths of K pixel islands in each pixel repetition unit row are shown in FIGS. 10 and 11. The 4 pixel islands corresponding to the 5 light splitting structures include 16 sub-pixels which are marked as a first sub-pixel 1 to a sixteenth sub-pixel 16, and the serial numbers of the sub-pixels represent the respective views (or viewpoints). The 4 pixel islands are a first pixel island S1, a second pixel island S2, a third pixel island S3, and a fourth pixel island S4. The first pixel island S1 includes a first sub-pixel 1, a sixth sub-pixel 6, an eleventh sub-pixel 11, and a sixteenth sub-pixel 16. The second pixel island S2 includes a fifth sub-pixel 5, a tenth sub-pixel 10, a fifteenth sub-pixel 15, and a fourth sub-pixel 4. The third pixel island S3 includes a ninth sub-pixel 9, a fourteenth sub-pixel 14, a third sub-pixel 3, and an eighth sub-pixel 8. The fourth pixel island S4 includes a thirteenth sub-pixel 13, a second sub-pixel 2, a seventh sub-pixel 7, and a twelfth sub-pixel 12. The light splitting structures corresponding to the 16 sub-pixels are marked as a first light splitting structure A1 to a fifth light splitting structure A5. As shown in FIG. 10, the first light splitting structure A1 covers the first sub-pixel 1, the sixth sub-pixel 6, the eleventh sub-pixel 11, and a part of the sixteenth sub-pixel 16; the second light splitting structure A2 covers the remaining part of the sixteenth sub-pixel 16, the fifth sub-pixel 5, the tenth sub-pixel 10, and a part of the fifteenth sub-pixel 15; the third light splitting structure A3 covers the remaining part of the fifteenth sub-pixel 15, the fourth sub-pixel 4, the ninth sub-pixel 9, and a part of the fourteenth sub-pixel 14; the fourth light splitting structure A4 covers the remaining part of the fourteenth sub-pixel 14, the third sub-pixel 3, the eighth sub-pixel 8, and the thirteenth sub-pixel 13; and the fifth light splitting structure A5 covers the second sub-pixel 2, the seventh sub-pixel 7, and the twelfth sub-pixel 12. As shown in FIG. 10, the relative positional relationship between the sub-pixels in the 4 pixel islands and the light splitting structures does not form a repetition unit, if the sub-pixels are sequentially spliced together according to a sequence of the views (or viewpoints) and the relative positions between the sub-pixels and the light splitting structures are kept unchanged, as shown in FIG. 11, after the sub-pixels corresponding to the light splitting structures are spliced together, the positions of the sub-pixels overlap each other, and the relative positional relationship between the sub-pixels and the light splitting structures forms a staggered and overlapped arrangement. Accordingly, the light emitting regions of the sub-pixels in the 4 pixel islands are spatially staggered, and also form a staggered and complementary arrangement in a space. As shown in FIG. 10, since a gap exists between any adjacent two of the first sub-pixel 1 and the fifth sub-pixel 5, light outgoing angles of light rays emitted from adjacent sub-pixels corresponding to a same light splitting structure in a space after passing through the same light splitting structure A are discontinuous, but since the relative positions of the sub-pixels in the 4 pixel islands and the 5 light splitting structures A are in a staggered and uniformly overlapped arrangement relationship, the light emitting regions of the sub-pixels in the 4 pixel islands are arranged uniformly and overlap with each other in the space, and thus the light outgoing angles of the light splitting structures A are also staggered and uniformly overlap each other. Since the size of each light splitting structure A is very small, human eyes cannot recognize which of the light splitting structures A light emits from. As such, as shown in FIG. 11, the human eyes perceive that the outgoing light emitted from 16 sub-pixels in 4 pixel islands and then being split by the 5 light splitting structures forms a continuous light emitting region in the space, and cannot see a "black region" when moving in the space.

In some embodiments, as shown in FIG. 10, in the row direction, a ratio of the total width n × h1 of the n sub-pixel openings to a width h2 of each pixel island is i/M, where i is an integer greater than 1 and less than or equal to M-1. That is, an aperture ratio of the sub-pixels in each pixel island is i/M. With such a configuration, the sub-pixels below each light splitting repetition unit are staggered and uniformly overlap with each other relative to the positions of the corresponding light splitting structures, such that the light emitting regions of the sub-pixels in the K pixel islands uniformly overlap with each other in a space, i.e., light paths of views (or viewpoints) uniformly overlap with each other, thereby eliminating macroscopic Moire fringes, and improving the display effect.

In a specific implementation, in the case where the light emitting regions of the sub-pixels in the K pixel islands uniformly overlap with each other in the space, a ratio of an area of the overlapping region of the light emitting regions of two sub-pixels with adjacent serial numbers to an area of the light emitting region of one of the two sub-pixels is (i-1)/i. The ratio of the area of the overlapping region of the light emitting regions of the two sub-pixels with adjacent serial numbers to an area of one of the two sub-pixels is (i-1)/M.

It should be noted that, in a case where in the row direction, the ratio of the total width n × h1 of the n sub-pixel openings to the width h2 of each pixel island is 1/M, i.e., when i = 1, the light emitting regions of the sub-pixels do not overlap each other in the space. When i = 2, the ratio of the area of the overlapping region of the light emitting regions of two sub-pixels with adjacent serial numbers to the area of the light emitting region of one of the two sub-pixels is 1/2, and the ratio of the area of the overlapping region of the light emitting regions of the two sub-pixels with adjacent serial numbers to an area of one of the two sub-pixels is 1/M. When i = 3, the ratio of the area of the overlapping region of the light emitting regions of two sub-pixels with adjacent serial numbers to an area of the light emitting region of one of the two sub-pixels is 2/3, and the ratio of the area of the overlapping region of the light emitting regions of the two sub-pixels with adjacent serial numbers to an area of one of the two sub-pixels is 2/M. When i = 4, the ratio of the area of the overlapping region of the light emitting regions of two sub-pixels with adjacent serial numbers to an area of the light emitting region of one of the two sub-pixels is 3/4, and the ratio of the area of the overlapping region of the light emitting regions of the two sub-pixels with adjacent serial numbers to an area of one of the two sub-pixels is 3/M. When i = M-1, the ratio of the area of the overlapping region of the light emitting regions of two sub-pixels with adjacent serial numbers to an area of the light emitting region of one of the two sub-pixels is (M-2)/(M-1), and the ratio of the area of the overlapping region of the light emitting regions of the two sub-pixels with adjacent serial numbers to an area of one of the two sub-pixels is (M-2)/M; and so on, detailed description thereof being omitted herein.

It should be noted that FIG. 10 exemplifies that the ratio of the total width of the n sub-pixel openings to the width of each pixel island in the row direction is (M-1)/M (i.e., 4/5), i.e., the aperture ratio of the sub-pixels in each pixel island in FIG. 4 is 4/5. In the case where the aperture ratio of the sub-pixels in each pixel island is (M-1)/M, the aperture ratio of the sub-pixels can be increased to the maximum extent while satisfying the requirement that the light emitting regions of the sub-pixels in the K pixel islands in the row direction uniformly overlap with each other in a space. Alternatively, in a specific implementation, the aperture ratio of the sub-pixels in each pixel island may be 2/M, 3/M, or the like.

In some embodiments, as shown in FIG. 12, the display device further includes:
a spacer dielectric layer 09 positioned between the light splitting assembly 02 and the display panel 01.

In some embodiments, each of the light splitting structures is a cylindrical lens.

In some embodiments, as shown in FIG. 12, the cylindrical lens 010 includes a first resin layer 011 having protrusions, and a planarization resin layer 012 on a side of the first resin layer 011 distal to the display panel 01. The planarization resin layer 012 has a refractive index smaller than a refractive index of the first resin layer 011.

Optionally, in some embodiments, the cylindrical lens is a liquid crystal lens.

Alternatively, in a specific implementation, each of the light splitting structures may be a geometric lens, a diffractive lens, a liquid lens, or the like, which is a structural device capable of controlling a light emitting direction of the sub-pixels.

In some embodiments, the display device further includes:
an eye tracking system for determining a position of an eye of a user in real time.

The display device according to an embodiment of the present disclosure may be a product or component with a display function, such as a mobile phone, a tablet computer, a television, a display, a notebook computer, a digital photo frame, a navigator, a smart watch, a fitness bracelet, a personal digital assistant, or the like. Other essential components of the display device should be understood by one of ordinary skill in the art, and are not described herein nor should they be construed as limiting the present disclosure.

To sum up, in the display device according to any one of the foregoing embodiments of the present disclosure, the M light splitting structures correspond to N columns of sub-pixels in each of the pixel repetition unit rows, where each of M and N is an integer greater than 1, i.e., the light splitting structures are in many-to-many correspondence with the sub-pixels. As such, each of the light splitting structures is prevented from having a too small size in the row direction, the difficulty of manufacturing the light splitting assembly is prevented from being increased, and the increase of a divergence angle of light emitted from the sub-pixels, the increase of crosstalk between views (or viewpoints), and the influence on the display effect, caused by the diffraction of each light splitting structure with a too small size can also be avoided. Further, the sub-pixels in at least some adjacent two pixel repetition unit rows are arranged in a staggered manner in the row direction, such that the distribution of the dark regions corresponding to the light splitting repetition units can be disturbed. As a result, the dark regions are arranged in a staggered manner, and the dark regions are prevented from consecutively forming a thin stripe in the column direction, thereby effectively mitigating the problem of microscopic Moire fringes.

Although preferred embodiments of the present disclosure have been described, additional variations and modifications in these embodiments may be made by one of ordinary skill in the art once he/she learn of the basic inventive concepts. Therefore, it is intended that the appended claims be interpreted as including the preferred embodiments and all variations and modifications that fall within the scope of the present disclosure.

It will be apparent to one of ordinary skill in the art that various modifications and variations may be made in the foregoing embodiments of the present disclosure without departing from the spirit or scope of these embodiments of the present disclosure. Thus, if such modifications and variations of these embodiments of the present disclosure fall within the scope of the claims of the present disclosure and their equivalents, the present disclosure is also intended to encompass these modifications and variations.

**Claims**

1.  A display device, comprising:

    a display panel, comprising a plurality of pixel repetition units arranged in an array along a row direction and a column direction, wherein each of the pixel repetition units comprises a plurality of pixel islands arranged consecutively in the column direction, each of the pixel islands comprises a plurality of sub-pixels arranged to be spaced apart from each other in the row direction, the plurality of pixel repetition units comprise a plurality of pixel repetition unit rows arranged in the column direction, and the sub-pixels in one pixel repetition unit row of a pair of adjacent two pixel repetition unit rows of at least some of pairs of adjacent two pixel repetition unit rows are staggered relative to the sub-pixels in the other pixel repetition unit row of the pair of adjacent two pixel repetition unit rows in the row direction; and
    a light splitting assembly, positioned on a display side of the display panel and comprising a plurality of light splitting repetition units which extend in the column direction and are consecutively arranged in the row direction, wherein each of the light splitting repetition units comprise M light splitting structures which extend in the column direction and are consecutively arranged in the row direction, and each light splitting repetition unit corresponds to N columns of the sub-pixels in each pixel repetition unit row, where each of M and N is an integer greater than 1, and M is coprime with N.

2.  The display device according to claim 1, wherein the plurality of pixel repetition unit rows are divided into a plurality of pixel repetition unit groups, and each of the pixel repetition unit groups comprises M pixel repetition unit rows;

    in each pixel repetition unit group, the sub-pixels in one pixel repetition unit row of any adjacent two pixel repetition unit rows are staggered relative to the sub-pixels in the other pixel repetition unit row of the adjacent two pixel repetition unit rows in the row direction;
    each pixel repetition unit group comprises subunits in one-to-one correspondence with the plurality of light splitting repetition units; and
    in each subunit, a ratio Jj of a staggered vector by which a c-th sub-pixel in a j-th pixel repetition unit row is staggered relative to the c-th sub-pixel in a first pixel repetition unit row in the row direction to a width of each sub-pixel in the row direction satisfies $Jj = \pm E/M$, where c is an integer greater than or equal to 1 and less than or equal to N, j is an integer greater than 1 and less than or equal to M, and E is an integer greater than or equal to 1, not equal to M, and not equal to an integer multiple of M.

3.  The display device according to claim 2, wherein in a 2-nd to an M-th pixel repetition unit rows in each subunit, Jj corresponding to any two pixel repetition unit rows is not equal to each other, and an absolute value of a difference between Jj corresponding to any two pixel repetition unit rows is not an integer greater than or equal to 1.

4. The display device according to claim 3, wherein for the pair of adjacent two pixel repetition unit rows of at least some of pairs of adjacent two pixel repetition unit rows in each subunit, a ratio ΔJ of a staggered vector by which the c-th sub-pixel in one pixel repetition unit row is staggered relative to the c-th sub-pixel in the other pixel repetition unit row in the row direction to the width of each sub-pixel in the row direction is not equal to $\pm C\dfrac{1}{M}$ or $\pm C\dfrac{M-1}{M}$ , where C is an integer greater than 0.

5. The display device according to any one of claims 2 to 4, wherein E is an integer greater than or equal to 1 and less than or equal to M-1.

6. The display device according to claim 5, wherein for the pair of adjacent two pixel repetition unit rows of at least some of pairs of adjacent two pixel repetition unit rows in each subunit, a ratio ΔJ of a staggered vector by which the c-th sub-pixel in one pixel repetition unit row is staggered relative to the c-th sub-pixel in the other pixel repetition unit row in the row direction to the width of each sub-pixel in the row direction is not equal to ± 1/M or ± (M-1)/M.

7. The display device according to any one of claims 2 to 6, wherein the sub-pixels in different subunits in a same pixel repetition unit row in each pixel repetition unit group have a same staggered vector.

8. The display device according to any one of claims 1 to 7, wherein each light splitting repetition unit corresponds to K columns of pixel islands in each pixel repetition unit row, where K is an integer greater than 1.

9. The display device according to claim 8, wherein N is coprime with K.

10. The display device according to claim 8, wherein N/K is an integer.

11. The display device according to claim 10, wherein each of the pixel islands comprises n sub-pixels arranged to be spaced apart from each other in the row direction, where n is an integer greater than 1; and
    each light splitting repetition unit corresponds to and covers K columns of pixel islands in at least part of pixel repetition unit rows, and N = K × n, where K is an integer greater than 1, and M is coprime with K.

12. The display device according to any one of claims 8 to 11, wherein outgoing light emitted from light emitting regions of N columns of sub-pixels in each pixel repetition unit row and then split by M light splitting structures forms a continuous light emitting region in a space.

13. The display device according to claim 12, wherein in the horizontal direction, a width of M light splitting structures is equal to a width of N columns of sub-pixels.

14. The display device according to claim 13, wherein each sub-pixel comprises a sub-pixel opening, and in the row direction, a ratio of a total width of n sub-pixel openings to a width of each pixel island is greater than or equal to 0.9/M and less than or equal to 1.

15. The display device according to claim 14, wherein in the row direction, the light emitting regions of N columns of sub-pixels in each pixel repetition unit row are complementarily spliced together in the space.

16. The display device according to claim 15, wherein in the row direction, a ratio of a width of each sub-pixel opening to the width of each pixel island is 1/M.

17. The display device according to claim 14, wherein in the row direction, the light emitting regions of N columns of sub-pixels in each pixel repetition unit row spatially overlap with each other.

18. The display device according to claim 17, wherein in the row direction, the light emitting regions of N columns of sub-pixels spatially overlap with each other uniformly.

19. The display device according to claim 18, wherein in the row direction, a ratio of a width of each sub-pixel opening to the width of each pixel island is i/M, where i is an integer greater than 1 and less than or equal to M-1.

20. The display device according to any one of claims 5 to 19, wherein M is 5, J2 is -2/5 or 3/5, J3 is 115 or -4/5, J4 is -1/5 or 4/5, and J5 is 2/5 or -3/5.

21. The display device according to any one of claims 1 to 20, further comprising:
    a spacer dielectric layer positioned between the light splitting assembly and the display panel.

22. The display device according to any one of claims 1 to 21, wherein each of the light splitting structures is one of a geometric lens, a diffractive lens, a liquid crystal lens, or a liquid lens.

**23.** The display device according to any one of claims 1 to 22, wherein each of the pixel repetition units comprises three pixel islands arranged consecutively in the column direction; and
in each pixel repetition unit, the sub-pixels of a same pixel island have a same display color, and the sub-pixels of different pixel islands have different display colors.

**24.** The display device according to any one of claims 1 to 23, wherein the display device further comprises: an eye tracking system for determining a position of an eye of a user in real time.

FIG. 1

| dark | slightly bright | brighter | brighter | slightly bright |
| --- | --- | --- | --- | --- |
| dark | slightly bright | brighter | brighter | slightly bright |
| dark | slightly bright | brighter | brighter | slightly bright |
| dark | slightly bright | brighter | brighter | slightly bright |

FIG. 2

FIG. 3

FIG. 4

| | | | | |
|------|------|------|------|------|
| 55.6 % | 78.3 % | 94.9 % | 94.9 % | 78.3 % |
| 94.9 % | 78.3 % | 55.6 % | 78.3 % | 94.9 % |
| 78.3 % | 94.9 % | 94.9 % | 78.3 % | 55.6 % |
| 78.3 % | 55.6 % | 78.3 % | 94.9 % | 94.9 % |
| 94.9 % | 94.9 % | 78.3 % | 55.6 % | 78.3 % |

FIG. 5

FIG. 6

FIG. 7

**FIG. 8**

| 2 | 1 | 2 | 3 | 4 | 5 | 6 | 7 | 8 | 9 | 10 | 11 | 12 | 13 | 14 | 15 | 16 |

FIG. 9

FIG. 10

A

| 1 | 6 | 11 | 16 |

| 5 | 10 | 15 |

| 4 | 9 | 14 |

| 3 | 8 | 13 |

| 2 | 7 | 12 |

FIG. 11

012  } 02(010)
011

09

01

FIG. 12

## INTERNATIONAL SEARCH REPORT

| International application No. |
|---|
| **PCT/CN2022/135658** |

### A. CLASSIFICATION OF SUBJECT MATTER

G02B30/27(2020.01)i; H04N13/305(2018.01)i

According to International Patent Classification (IPC) or to both national classification and IPC

### B. FIELDS SEARCHED

Minimum documentation searched (classification system followed by classification symbols)

IPC: G02B H04N

Documentation searched other than minimum documentation to the extent that such documents are included in the fields searched

Electronic data base consulted during the international search (name of data base and, where practicable, search terms used)

CNABS, CNTXT, ENTXT, ENTXTC, VEN: 高健, 董学, 洪涛, 彭宽军, 吴仲远, 京东方, 三维, 立体, 显示, 错位, 交错, 错开, 偏移, 移位, 移动, 位移, 平移, 像素, 象素, 发光, 画素, 摩尔, 条纹, 亮纹, 暗纹, 黑纹, 莫尔, 黑区, 暗区, 波纹, 分光, 光栅, 透镜, 棱镜, 分离, 视差, 障栅, 质, 公约数, 公因数, 倍数, three dimensional, 3 dimensional, 3D, stereo, displace, shift, offset, stagger, deviation, displacement, move, pixel, light, moire, pattern, stripe, line, ripple, fringe, light spilt, raster, grate, lens, prism, prime, common divisor, multiple

### C. DOCUMENTS CONSIDERED TO BE RELEVANT

| Category* | Citation of document, with indication, where appropriate, of the relevant passages | Relevant to claim No. |
|---|---|---|
| Y | WO 2022155969 A1 (BOE TECHNOLOGY GROUP CO., LTD.) 28 July 2022 (2022-07-28) description, page 5, paragraph 5-page 14, paragraph 4, and figures 3-19 | 1-24 |
| Y | WO 2012026391 A1 (HITACHI LTD. et al.) 01 March 2012 (2012-03-01) description, paragraphs [0011]-[0073], and figures 1-15 | 1-24 |
| A | CN 115220241 A (BOE TECHNOLOGY GROUP CO., LTD.) 21 October 2022 (2022-10-21) entire document | 1-24 |
| A | CN 111766716 A (BOE TECHNOLOGY GROUP CO., LTD.) 13 October 2020 (2020-10-13) entire document | 1-24 |
| A | CN 103945203 A (SHANGHAI TIANMA MICROELECTRONICS CO., LTD. et al.) 23 July 2014 (2014-07-23) entire document | 1-24 |

☑ Further documents are listed in the continuation of Box C. ☑ See patent family annex.

| * | Special categories of cited documents: |
|---|---|
| "A" | document defining the general state of the art which is not considered to be of particular relevance |
| "D" | document cited by the applicant in the international application |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
|---|---|
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| **29 August 2023** | **30 August 2023** |

| Name and mailing address of the ISA/CN | Authorized officer |
|---|---|
| **China National Intellectual Property Administration (ISA/CN)** **China No. 6, Xitucheng Road, Jimenqiao, Haidian District, Beijing 100088** | |
| | Telephone No. |

Form PCT/ISA/210 (second sheet) (July 2022)

**INTERNATIONAL SEARCH REPORT**

International application No.

**PCT/CN2022/135658**

**C.     DOCUMENTS CONSIDERED TO BE RELEVANT**

| Category* | Citation of document, with indication, where appropriate, of the relevant passages | Relevant to claim No. |
|---|---|---|
| A | CN 103278954 A (SHANGHAI TIANMA MICROELECTRONICS CO., LTD.) 04 September 2013 (2013-09-04)<br>entire document | 1-24 |
| A | JP 2006106608 A (CANON K. K.) 20 April 2006 (2006-04-20)<br>entire document | 1-24 |

Form PCT/ISA/210 (second sheet) (July 2022)

**INTERNATIONAL SEARCH REPORT**
Information on patent family members

| International application No. |
| --- |
| **PCT/CN2022/135658** |

| Patent document cited in search report | | | Publication date (day/month/year) | Patent family member(s) | | | Publication date (day/month/year) |
| --- | --- | --- | --- | --- | --- | --- | --- |
| WO | 2022155969 | A1 | 28 July 2022 | EP | 4120006 | A1 | 18 January 2023 |
| | | | | EP | 4120006 | A4 | 21 June 2023 |
| | | | | US | 2023164302 | A1 | 25 May 2023 |
| WO | 2012026391 | A1 | 01 March 2012 | JP | 2012047769 | A | 08 March 2012 |
| | | | | JP | 5568409 | B2 | 06 August 2014 |
| CN | 115220241 | A | 21 October 2022 | | None | | |
| CN | 111766716 | A | 13 October 2020 | | None | | |
| CN | 103945203 | A | 23 July 2014 | US | 2015181202 | A1 | 25 June 2015 |
| | | | | US | 9699443 | B2 | 04 July 2017 |
| | | | | DE | 102014109602 | A1 | 25 June 2015 |
| | | | | DE | 102014109602 | B4 | 03 August 2023 |
| CN | 103278954 | A | 04 September 2013 | | None | | |
| JP | 2006106608 | A | 20 April 2006 | | None | | |

Form PCT/ISA/210 (patent family annex) (July 2022)